Europäisches Patentamt

European Patent Office

Office européen des brevets

(11) Publication number: **0 357 779**
**A1**

# EUROPEAN PATENT APPLICATION
## published in accordance with Art. 158(3) EPC

(21) Application number: 89900917.9

(22) Date of filing: 26.12.88

(86) International application number:
PCT/JP88/01334

(87) International publication number:
WO 89/06432 (13.07.89 89/15)

(51) Int. Cl.5 **H01B 12/04 , H01B 13/00**

(30) Priority: 25.12.87 JP 328673/87
25.12.87 JP 328674/87

(43) Date of publication of application:
**14.03.90 Bulletin 90/11**

(84) Designated Contracting States:
**DE FR GB**

(71) Applicant: **MITSUBISHI KINZOKU KABUSHIKI KAISHA**
**5-2, Otemachi 1-chome**
**Chiyoda-ku Tokyo(JP)**

(72) Inventor: **HAGINO, Sadaaki**
**7-203, 33-8, Harayama 2-chome**
**Urawa-shi Saitama 336(JP)**
Inventor: **SUZUKI, Motokazu**
**1135-4, Shima-cho**
**Omiya-shi Saitama 330(JP)**
Inventor: **KONDO, Hideyuki**
**279, Niitsutsumi**
**Ohaza, Omiya-shi Saitama 330(JP)**
Inventor: **NISHIKAWA, Shigeru**
**Mitsubishi Kinzoku K. K. Taiseiryo**
**1-545, Onari-cho Omiya-shi Saitama 330(JP)**

(74) Representative: **Andrae, Steffen, Dr.**
**Patentanwälte Andrae, Flach, Haug**
**Steinstrasse 44**
**D-8000 München 80(DE)**

(54) SUPERCONDUCTIVE WIRE AND CABLE HAVING HIGH CURRENT DENSITY, AND METHOD OF PRODUCING THEM.

(57) A superconductive structure comprising an oxide superconductive ceramic powder having a perovskite structure and a metallic covering member or, preferably, an Ag covering member which encloses said powder, wherein a compression oriented layer is formed maintaining a thickness of greater than 5 $\mu$m in which the C-axis direction of crystals of the powder is oriented perpendicularly to the lengthwise direction of the superconductive structure. The invention further deals with a method of producing the same.

## FIG. 1

SPECIFICATION

SUPERCONDUCTING WIRE AND CABLE
HAVING HIGH CURRENT DENSITY,
AND
PROCESSES FOR FABRICATING THEM

TECHNICAL FIELD

This invention relates to superconducting wire and cable each having high current density, and to a process for fabricating them.

BACKGROUND ART

Generally, it is known that a compound having a perovskite structure and comprising Y-including rare earth element (hereinafter, indicated by a symbol R), an alkaline earth metal (hereinafter, indicated by a symbol A), copper (Cu) and oxygen (O) (hereinafter, the compound being referred to as a superconducting ceramics) indicates superconductive phenomena at a temperature of 77°K which is able to be achieved by liquidal nitrogen.

It is known that a process for fabricating a superconducting ceramics wire using the above-described superconducting ceramics powder includes the following steps:

providing starting powders, i.e., an $R_2O_3$ powder, an alkaline earth metal carbonate powder as the component $A$, and CuO powder, each having an average grain size of not greater than 10 $\mu$m, compounding and mixing them in a predetermined compounding ratio, to obtain a mixed powder, calcining the mixed powder in the air or in an oxygenic atmosphere, at a temperature of from 850 to 950°C to form a superconducting ceramics having a perovskite structure, and grinding the ceramics to obtain powder of an average grain size of not greater than 10 μm,

filling a pipe of silver (Ag) with the superconducting powder ground in the previous step, sealing the both ends of the pipe under vacuum, and subjecting the silver pipe filled with the ground powder to cold-drawings, e.g., swaging, rolling with grooved rolls, processing with a die, or the like, to produce a wire having a diameter of not greater than 5 mm,

heat-treating the wire in the air or an oxygenic atmosphere at sintering temperatures (for example, in the case of using Y-based superconducting ceramics oxide, the temperatures being within from 900 to 950°C) to produce a superconducting wire.

Also, a process for fabricating a superconducting cable comprises the steps:

bundling a plurality of such wires produced by cold-drawing, covering the bundled wires with a tube of Ag to form a cable, and then subjecting the cable to processing with a die, if required, to produce a superconducting cable.

However, although critical current density, $J_c$, of superconducting wires and cables produced by the above-described conventional processes each indicates orders of $10^3 A/cm^2$, critical current density, $J_c$, of superconducting wires and cables for practical use each is necessary to be at least $10^4 A/cm^2$.

A process for satisfying the thus requirement comprises the steps of: preparing a mono-crystalline of a superconducting ceramics having a perovskite structure, and fabricating a superconducting wire using the mono-crystalline in which an electric current sends therethrough perpendicularly to a C axial direction of the mono-crystalline, and the resulting superconducting wire having critical current density of greater than $10^4 A/cm^2$ can be produced (it is generally said that the above-described superconducting ceramics has high anisotropy of crystalline, and then an electric current hardly sends along the C axial direction, but easily sends perpendicularly to the C axial direction, and the electric current along the C axial direction is not greater than about 1/100 of one perpendicularly to the C axial direction.). Even when it is possible to produce experimentally thus mono-crystalline of the superconducting ceramics having a long-length wired-shape, it is impossible to produce industrially it at the present time.

Also, in the case of the superconducting cable, although it is possible to produce a cable which comprises by bundling wires, the wires each comprising by filling an Ag sheath with superconducting mono-crystal fibers each having a perovskite structure, and each having a C axis whose direction of the mono-crystalline which is perpendicular to a longitudinal direction of the fiber, it is difficult to produce such mono-crystal fibers at the present time, and it is also impossible to produce a superconducting cable, comprising by bundling wires which are filled with the mono-crystal fibers.

## DISCLOSURE OF THE INVENTION

Accordingly, the present inventors have intensively investigated production of superconducting wires and cables each having critical current density of orders of $10^4 A/cm^2$, and have found the following facts:

(1) When the superconducting ceramics powder is subjected to molding under pressure to form a molded body, a layer in which the C axis of crystalline of the powder is oriented perpendicularly to a pressed face (hereinafter, the layer being referred to as a compressed oriented layer) is formed at a surface of the molded body. Thickness of the compressed oriented layer depends upon a pressure which is exerted on the layer by the molding operation.

(2) Orientation and thickness of the compressed oriented layer, which is formed at the surface of the molded body, are stable even when they are sintered by heat-treatment.

(3) Such compressed oriented layer having thickness of not greater than 5 $\mu$m is formed at an inner face of an Ag sheath of the conventional superconducting wire filled the superconducting ceramics powder therein. It is considered that a superconductive electric current is mainly sent through the compressed oriented layer in which the C axis of the superconducting ceramics powder is oriented perpendicularly to a longitudinal direction of the superconducting wire.

The present inventors have further investigated on the basis of such facts, and have found that the superconducting wire having a compressed oriented layer having a thickness of greater than 5 $\mu$m, in which the C axes of all crystalline have the same direction each other which is perpendicular to a longitudinal direction of the wire, can be produced by subjecting a pipe filled with the superconducting ceramics powder to swaging and then rolling with grooved rolls, and further rolling the superconducting wire obtained by such drawing so that a reduction ratio becomes one greater than about 30%. The critical current density of the wire having the compressed oriented layer of a thickness of greater than 5 $\mu$m can be improved so as to become a value of greater than $10^4 A/cm^2$.

The present inventors have also found that a cable having the compressed oriented layer which is larger than the conventional one and having high critical current density can be produced by filling a pipe made of Ag with a plurality of superconducting wires, which is subjected to drawing without rolling operations, further drawing the pipe to form a cable comprising a superconducting ceramics filled therein as closely as possible, and as a final step, rolling the cable so that a reduction ratio becomes one greater than about 30%.

This invention has been made on the basis of the above-described discoveries.

It is a first object of this invention to provide a superconducting structural body, i.e., superconducting wires or cables, comprising an oxide based superconducting ceramics powder having a perovskite structure, and a covering body made of metals, preferably Ag, filling the oxide based superconducting ceramics powder therein, the superconducting structural body having a compressed oriented layer of thickness of greater than 5 μm, in which the C axis of crystalline of the superconducting ceramics powder is oriented perpendicularly to a longitudinal direction of the superconducting structural body.

It is a second object of this invention to provide a superconducting wire comprising an oxide based superconducting ceramics powder having a perovskite structure, and a covering body made of metals, preferably Ag, filling an oxide based superconducting ceramics powder therein, the superconducting wire having a compressed oriented layer of thickness of greater than 5 μm, in which the C axis of crystalline of the superconducting ceramics powder is oriented perpendicularly to a longitudinal direction of the superconducting wire.

It is a third object of this invention to provide a superconducting cable comprising a plurality of metals, preferably Ag-covered superconducting wires filled with an oxide based superconducting ceramics powder of a perovskite structure, and a pipe made of metals, preferably Ag, the superconducting cable having a compressed oriented layer of thickness of greater than 5 μm, in which the C axis of crystalline of the superconducting ceramics powder is oriented perpendicularly to a longitudinal direction of the superconducting cable.

It is a fourth object of this invention to provide a process for fabricating a superconducting structural body having a compressed oriented layer of thickness of greater than 5 μm, in which the C axis of crystalline of the superconducting ceramics powder is oriented perpendicularly to a longitudinal direction of the superconducting structural body, the process comprising of rolling the superconducting structural body comprising an oxide based superconducting ceramics powder and an Ag-covering body filling the powder therein so that a reduction ration becomes one greater than about 30%.

It is a fifth object of this invention to provide a process for fabricating a superconducting wire, the process comprising the steps of: filling a sheath made of metals, preferably Ag with an oxide based superconducting ceramics powder of a perovskite structure, drawing the superconducting ceramics powder filled sheath to obtain a superconducting wire, rolling the superconducting wire obtained by the drawing operation, with a flat roll so that a reduction ratio becomes one greater than about 30%, and heat-treating the wire rolled at sintering temperatures enough for sintering the superconducting ceramics.

It is a sixth object of this invention to provide a process for fabricating a superconducting cable, comprising the steps of: filling a pipe made of metals, preferably Ag with a plurality of superconducting wires filled with an oxide based superconducting ceramics powder of a perovskite structure, drawing the pipe filled with a plurality of the superconducting wires to form a cable, rolling the cable with a flat roll so that a reduction ratio becomes one greater than about 30%, and heat-treating the rolled cable at sintering temperatures enough for sintering the superconducting ceramics.

## BRIEF DESCRIPTION OF DRAWINGS

Figures 1 through 4 show schematical perspective views of cross sections of superconducting wires each indicating high critical current density according to this invention, respectively;

Figures 5 through 8 show schematical perspective views of each step of a flow chart of working superconducting cables according to this invention, respectively; and

Figures 9 through 13 show charts of X-ray diffraction of a compressed oriented layer formed at a surface layer of a superconducting ceramics powder filled in a superconducting complex wire according to this invention, the charts being obtained by investigation of the layer, respectively.

BEST MODE FOR CARRYING OUT THE INVENTION

In this invention, not only Y-including rare earth elements based superconducting ceramics oxide but also Bi-based superconducting ceramics oxide such as $BiSrCaCu_2O_y$, $Bi_2Sr_2Ca_2Cu_3O_y$, $(Bi,Pb)SrCaCuO_{1.5-2}$, Tl-based superconducting ceramics oxide such as $Tl_2Ba_2Ca_2Cu_3O_x$, $Tl(Ba,Sr)_2CaCuO$, can be used as superconducting ceramics, as far as the superconducting ceramics has a perovskite structure.

In this invention, there can be used, as a material for a metal covering body (sheath, pipe), for example, nickel alloys such as Inconel and Hastelloy, stainless steel, silver (Ag), or the like, which are generally used in the superconducting wires and cables. Of these, Ag is preferably used from a viewpoint of oxygen permeation and the like. There can be used, as a material for the Ag portion, not only pure Ag but also Ag-based alloys which contain one or more metals such as platinum (Pt) that do not react with the superconducting ceramics and give a good influence upon the strength of the superconducting wires in amounts not preventing oxygen permeation.

Hereinafter, characteristics and advantages of this invention will be explained in greater detail, with reference to the best modes of this invention illustrated in the attached drawings.

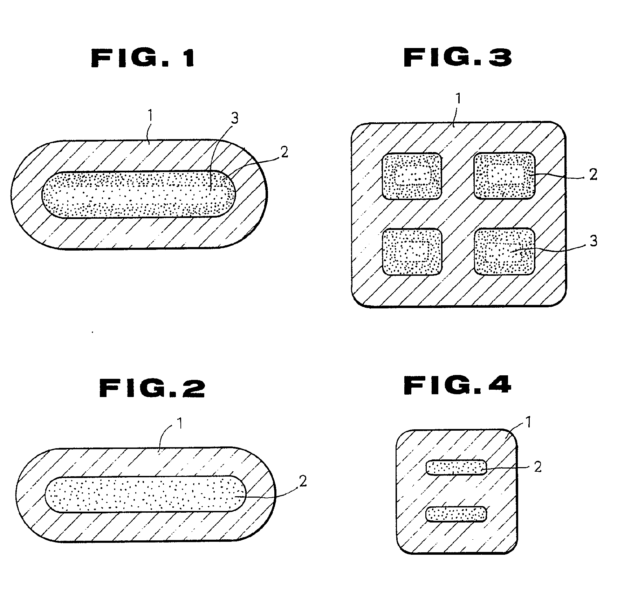

Figures 1 through 4 show schematical perspective views of cross sections of superconducting wires each indicating high critical current density according to this invention, respectively, reference numeral 1 denotes a sheath made of Ag, numeral 2 denotes a compressed oriented layer of a superconducting ceramics powder, and numeral 3 denotes the superconducting ceramics powder. The above-described compressed oriented layer of the superconducting ceramics powder represents a layer in which the C axes of all crystalline of the powder have the same direction each other which is perpendicular to a longitudinal direction of the superconducting wire. The compressed oriented layer 2 is not restricted to a shape which is identical to the cross section of the superconducting wire as shown in Figures 2 and 4. It may take a structure in which a peripheral portion extending in a circumferential direction of an inner face of the Ag sheath is the compressed oriented layer as shown in Figures 1 and 3, the peripheral portion being a part of the superconducting ceramics powder filled in the superconducting wires. In each of the cases of the wires shown in Figures 2 and 4, the superconducting ceramics powder is compressed from upper and lower sides at a reduction ratio of greater than about 30% to form a compressed oriented layer of a thickness of greater than 5 μm (in the case of Y based superconducting ceramics, the thickness being in the range of 5 to 150 μm) at the inner face of the Ag sheath 1.

In the case of wires shown in Figures 1 and 3, each of the compressed oriented layers is formed at the upper and lower sides of the inner faces of the sheath made of Ag, and a total thickness of the both layers is in the range of 10 to 300 μm (in the case of Y based superconducting ceramics), or greater than 300 μm (in the case of Bi based superconducting ceramics and Tl based superconducting ceramics).

The superconducting wires each having a cross section illustrated in Figures 3 and 4 can be fabricated by the following steps: providing a composite pipe having a plurality of holes, filling the superconducting ceramics in the holes of the composite pipe, subjecting the composite pipe filled the superconducting ceramics therein to rolling with grooved roll to form a superconducting wire, and subjecting the superconducting wire rolled with grooved roll to rolling with a flat roll at a reduction ratio of greater than about 30%. The superconducting wires each having a cross section illustrated in Figures 3 and 4 can be also fabricated by bundling four superconducting wires each having a cross section of band-shape illustrated in Figure 1 or 2, or stacking two superconducting wires described above, and then compressing them.

The cross sections of the superconducting wire having high critical current density of this invention are not restricted to ones which are shown in Figures 1 through 4, and may take any desired cross section other than the above cases.

The reason why the above-described superconducting wire drawn is further rolling at a reduction ratio of greater than about 30% will be explained below.

In the superconducting wire comprising by filling conventional superconducting ceramics powders in an Ag pipe and drawing the Ag pipe, the superconducting ceramics powder is only filled therein as close as possible, and in this case, a thickness of a compressed oriented layer of the wire is at most 5 μm. In order to increase the thickness of the compressed oriented layer so as to be greater than 5 μm, it is necessary that the superconducting wire drawn is further rolled at a reduction ratio of greater than about 30%, preferably 50%. In this case, it is achieved to form a compressed oriented layer having a thickness of greater than 5 μm at an inner face of the Ag sheath.

Meanwhile, the reduction ratio is represented by the following equation:

Reduction Ratio = {(h$_0$ - h)/h$_0$} x 100(%)

wherein h$_0$ denotes a diameter or thickness of superconducting ceramics filled structure prior to rolling, e.g., wire or flat-shaped wire, or the like, and h denotes a thickness of the structure after rolling with a flat roll.

Rolling with a flat roll at a reduction ratio of greater than about 30%, preferably 50% may be achieved by one or more passes. The rolling is desired to be performed as quickly as possible.

Even when the superconducting ceramics filled wire having the compressed oriented layer formed by the above-described process is finally subjected to heat-treatment in the air or in an oxygenic atmosphere at sintering temperature enough to sinter the superconducting ceramics, a C axial direction and thickness of the compressed oriented layer are stable.

The same rolling in the process for fabricating the superconducting cable of this invention as one in the process for fabricating the superconducting wire is repeated.

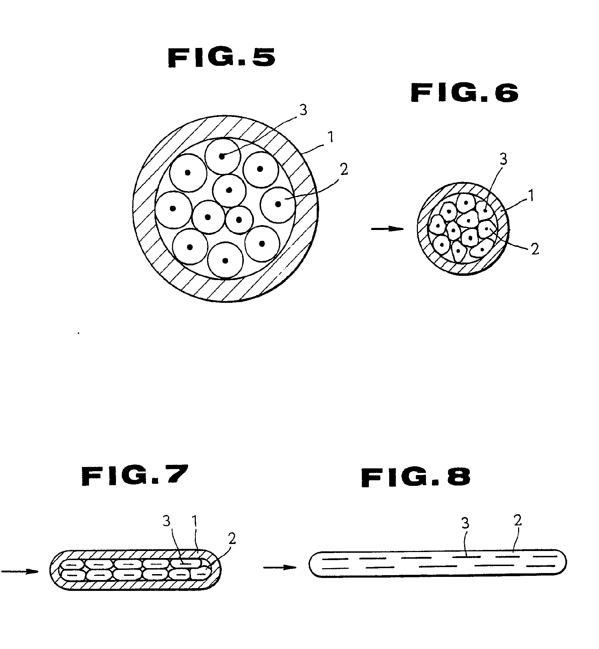

Figures 5 through 8 show steps of fabricating a superconducting cable of this invention. In Figures 5 through 8, reference numeral 11 denotes a pipe made of Ag, numeral 12 denotes a sheath made of Ag, and numeral 13 denotes a superconducting ceramics powder. The process for fabricating the superconducting cable comprises by providing a plurality of wires comprising the Ag sheath 12 and the superconducting ceramics 13, filling the wires in the Ag pipe 11 as shown in Figure 1, drawing the Ag pipe to form a cable having a reduced diameter as shown in Figure 2, and further rolling the cable so as to be further flat-shape as shown in Figure 3. This final step may be omitted, if not required.

Subsequently, the flat cable rolled in the previous step is subjected to rolling with a flat roll at a reduction ratio of greater than about 30%, preferably 50%. By the rolling operations, the Ag pipe and Ag sheath are compressed and solid each other (Figure 4).

The thus-fabricated superconducting cable is heat-treated in the air or in an oxygenic atmosphere at sintering temperatures enough to sinter the above-described superconducting ceramics to form a superconducting cable.

EXAMPLES

Next, the present invention will be concretely explained with reference to the following examples.

Example 1

As starting powder, $Y_2O_3$ powder, $BaCO_3$ powder and CuO powder each having an average grain size of 6 μm are provided and blended in a blend ratio: $Y_2O_3$:15.13%, $BaCO_3$:52.89%, CuO:31.98% (% by weight). The blended powder are calcined in the air, at a temperature of 900°C, for a retention time of 10 hours, and then ground to obtain powder having an average grain size of 2.6 μm. Thus, a superconducting ceramics powder is produced which has a composition of $YBa_2Cu_3O_7$ and has a perovskite structure.

(1) The above-described superconducting ceramics is filled in an Ag pipe having dimensions of inner diameter: 7 mm x thickness: 1.5 mm, sealed the Ag pipe, subjected the above-described superconducting ceramics powder filled Ag pipe sealed to rotary-swaging to form a wire having a diameter of 3 mm, rolling the wire with two flat rolls to form a band-shaped wire having a thickness of 1.0 mm, and further subjecting the band-shaped wire to rolling with a flat roll at a reduction ratio of 60% at one pass to form a band-shaped superconducting wire having a thickness of 0.4 mm.

The above-described superconducting wire is heat-treated in the air at a temperature of 920°C at a retention time of 15 hours, and then critical current density, Jc, thereof is measured to obtain Jdc: $1.5 \times 10^4 A/cm^2$. The above-described band-shaped superconducting wire is cut, and then a test of orientation of the above-described superconducting ceramics powder filled layer is performed by X-ray diffraction, a compressed oriented layer, in which the C axial direction of crystalline of the powder is oriented perpendicularly to a longitudinal direction of the band-shaped superconducting wire, is formed at all of the above-described filled layer. The cross sectional structure of the band-shaped superconducting wire is substantially shown in Figure 2.

(2) Two of the band-shaped superconducting wires each having a thickness of 0.4 mm are stacked, and then rolled with a flat roll at a reduction ratio of 75% to produce a composite superconducting wire. The critical current density, Jc, of the composite superconducting wire is measured to obtain Jc: $1.8 \times 10^4 A/cm^2$. The above-described composite superconducting wire is cut, and then a thickness of the superconducting ceramics powder filled layer is measured. As a result, it has been observed that the superconducting ceramics powder filled layer comprises two layers. Tests of orientation of these layers are performed by X-ray diffraction, and it has been observed that the two layers comprise a compressed oriented layer, in which the C axial direction of crystalline of the powder is oriented perpendicularly to a longitudinal direction of the band-shaped superconducting wire. The cross sectional structure of the composite superconducting wire is substantially shown in Figure 4.

Example 2

As starting powder, $Y_2O_3$ powder, $BaCO_3$ powder and CuO powder each having an average grain size of 6 μm are provided and blended in a blend ratio: $Y_2O_3$:15.13%, $BaCO_3$:52.89%, CuO:31.98% (% by weight). The blended powder are calcined in the air, at a temperature of 900°C, for a retention time of 10 hours, and then ground to obtain powder having an average grain size of 2.8 μm. Thus, a superconducting ceramics powder is produced which has a composition of $YBa_2Cu_3O_7$ and has a perovskite structure.

A pipe of Ag having dimensions of inner diameter: 7 mm x thickness: 1.5 mm is filled with the superconducting ceramics powder thus obtained, and both ends thereof are sealed. Subsequently, the Ag pipe is subjected to drawing to produce a wire having a diameter of 2 mm.

Eleven wires thus obtained are provided and filled in a pipe of Ag having dimensions of inner diameter: 8 mm x thickness: 1.2 mm (Figure 1).

The Ag pipe filled the wires therein are subjected to drawing to produce a cable having an outer diameter of 3.2 mm (Figure 2), and then rolling with a flat roll (Figure 3). Subsequently, the rolled flat cable is further rolled with a flat roll at a reduction ratio of 60% at one pass. Thus, the above-described Ag pipe and the Ag sheath are compressed and solid each other (Figure 4).

The thus-obtained superconducting cable is heat-treated in an oxygenic atmosphere at a temperature of 920°C at a retention time, and critical current density, Jc, thereof is measured to obtain Jc: $2.4 \times 10^4 A/cm^2$. The superconducting cable is cut, and it has been observed that a plurality of superconducting ceramics layers each having a thickness of 20 μm are formed. A test of orientation of the superconducting ceramics layer exposed on the cross section is performed by X-ray

EP 0 357 779 A1

diffraction, it has been observed that a compressed oriented layer, in which the C axial direction of crystalline of the powder is oriented perpendicularly to a longitudinal direction of the band-shaped superconducting wire, is formed at all of the filled layer.

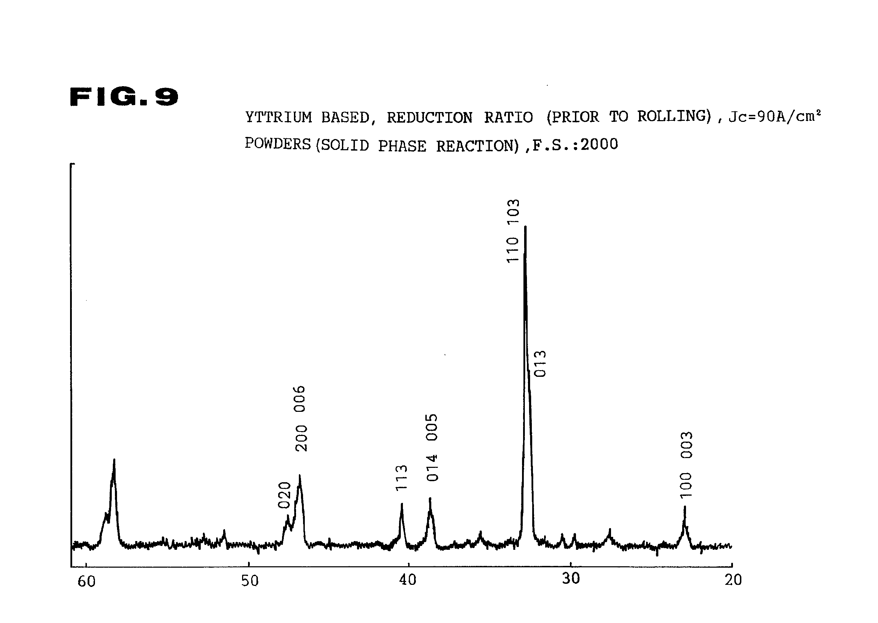

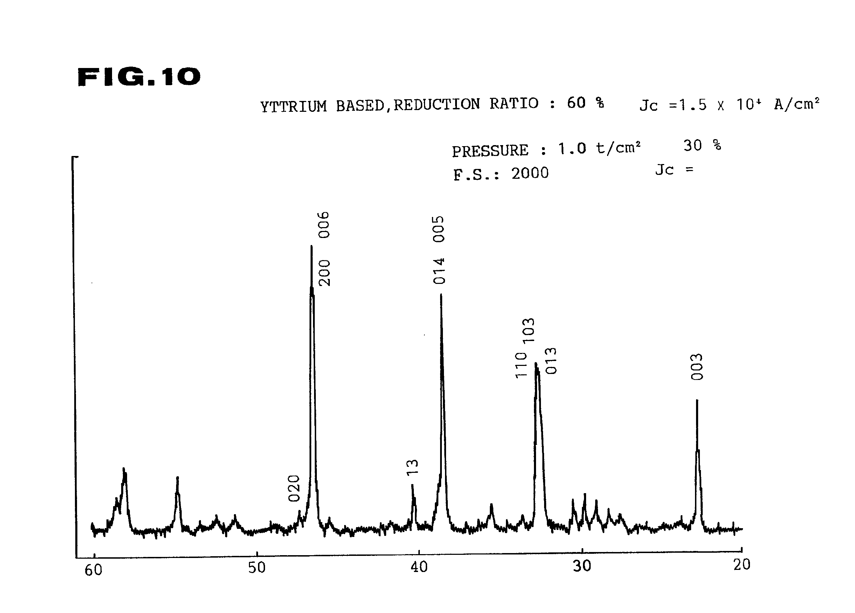

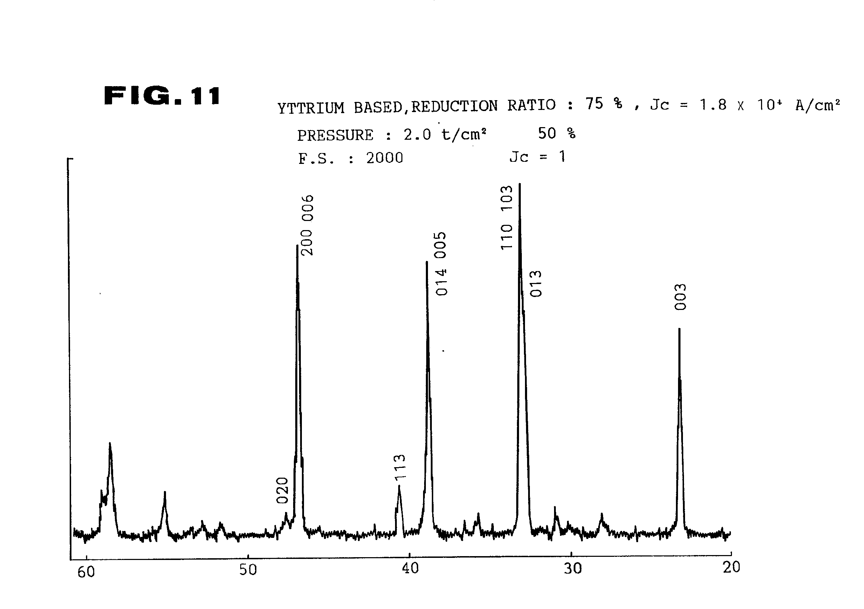

The compressed oriented layers of the above-produced superconducting composite wires or cables is measured by X-ray diffraction and the results are shown in Figures 9 through 13.

Example 3

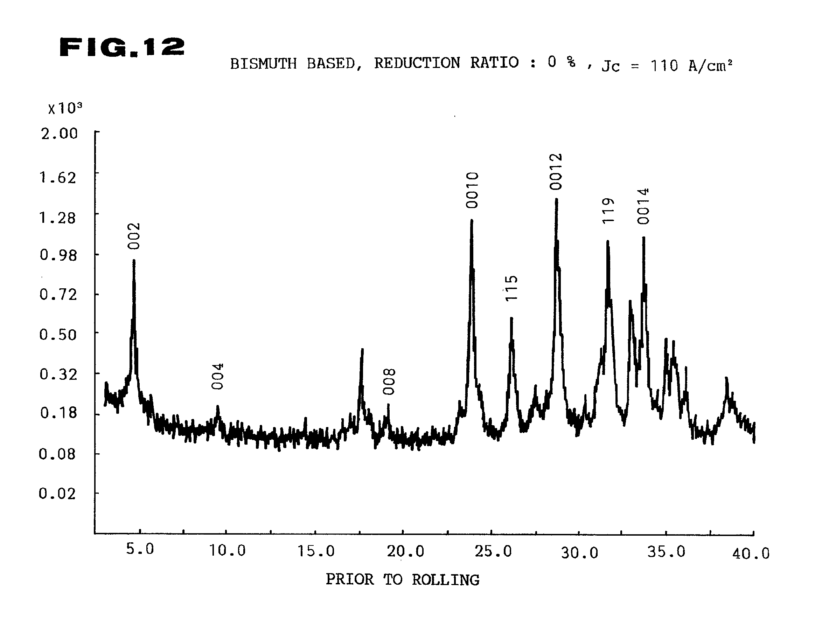

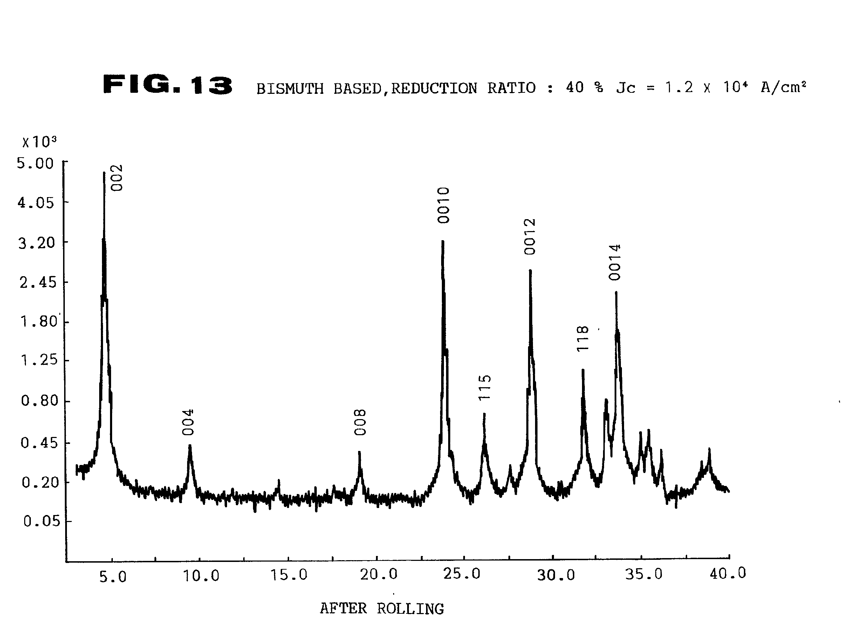

The same procedures as in Example 1 are repeated to fabricate superconducting wires, except that Bi based oxide or Tl based oxide is used as Y based oxide. Tests of orientation of the superconducting ceramics layers of the superconducting wires are performed by X-ray diffraction to obtain a result which is similar to that of Example 1. The result measured by X-ray diffraction using Bi based superconducting ceramics oxide is shown in Figures 12 and 13.

The above-described Bi based superconducting ceramics oxide is prepared by providing $Bi_2O_3$ powder, $CaCO_3$ powder, $SrCO_3$ powder and $CuO$ powder as starting powder, compounding and mixing them in a predetermined compounding ratio to obtain a mixed powder, and calcining the mixed powder in the air at a temperature of from 700 to 800°C at a retention time of from 4 to 12 hours. Also, the Tl based superconducting ceramics oxide is prepared by providing $Tl_2O_3$ powder, $CaCO_3$ powder, $BaCO_3$ powder and $CuO$ powder as starting powder, compounding and mixing them in a predetermined compounding ratio to obtain a mixed powder, and calcining the mixed powder in the air at a temperature of from 600 to 700°C at a retention time of from 4 to 12 hours.

## INDUSTRIAL APPLICABILITY

This invention has effects that superconducting wires and cables each having high critical current density can be easily fabricated using the conventional superconducting ceramics powder.

CLAIMS:

1.   A superconducting structural body comprising an oxide based superconducting ceramics powder having a perovskite structure and a covering body made of metal, preferably Ag filling the oxide based superconducting ceramics powder therein, the superconducting structural body having a compressed oriented layer in which a C axial direction of crystalline of the powder is oriented perpendicularly to a longitudinal direction of the superconducting structural body and in which a thickness thereof is greater than 5 $\mu$m.

2.   A superconducting wire comprising an oxide based superconducting ceramics powder having a perovskite structure and a metal sheath filling the oxide based superconducting ceramics powder therein, the superconducting structural body having a compressed oriented layer in which a C axial direction of crystalline of the powder is oriented perpendicularly to a longitudinal direction of the superconducting wire and in which a thickness thereof is greater than 5 $\mu$m.

3.   A superconducting cable comprising a plurality of metal covered superconducting wires filled oxide based superconducting ceramics powder having a perovskite structure therein and a pipe made of metal, the superconducting structural body having a compressed oriented layer in which a C axial direction of crystalline of the powder is oriented perpendicularly to a longitudinal direction of the superconducting wire and in which a thickness thereof is greater than 5 $\mu$m.

4.   A process for fabricating a superconducting structural body comprising by rolling the superconducting structural body comprising an oxide based superconducting ceramics powder having a perovskite structure and a covering body made of metal at a reduction ratio of greater than about 30% so that a compressed oriented layer, in which a C axial direction of crystalline of the powder is oriented perpendicularly to a longitudinal direction of the superconducting structural body and in which a thickness thereof is greater than 5 $\mu$m, is formed.

5. A process for fabricating a superconducting wire comprising the steps: filling oxide based superconducting ceramics powder having a perovskite structure in a sheath made of metal, drawing the the sheath filled with the oxide based superconducting ceramics powder to form a superconducting wire, subjecting the superconducting wire to rolling with a flat roll at a reduction ratio of greater than about 30%, and heat-treating the rolled wire at sintering temperatures enough to sinter the superconducting ceramics.

6. A process for fabricating a superconducting cable comprising the steps: filling a plurality of superconducting wires in a pipe made of metal, the superconducting wires each comprising by filling oxide based superconducting ceramics powder having a perovskite structure, drawing the pipe filled with a plurality of the superconducting wires to produce a cable, subjecting the cable to final rolling with a flat roll so that a reduction ratio becomes greater than about 30%, and heat-treating the rolled cable at sintering temperatures enough to sinter the superconducting ceramics.

## FIG. 1

## FIG. 3

## FIG.2

## FIG. 4

**FIG.5**

**FIG.6**

**FIG.7**

**FIG.8**

**FIG.9**

YTTRIUM BASED, REDUCTION RATIO (PRIOR TO ROLLING), Jc=90A/cm²
POWDERS (SOLID PHASE REACTION), F.S.:2000

EP 0 357 779 A1

# FIG.10

YTTRIUM BASED, REDUCTION RATIO : 60 %     Jc =1.5 × 10⁴ A/cm²

PRESSURE : 1.0 t/cm²     30 %

F.S.: 2000     Jc =

EP 0 357 779 A1

# FIG.11

YTTRIUM BASED,REDUCTION RATIO : 75 % , Jc = 1.8 x 10⁴ A/cm²

PRESSURE : 2.0 t/cm²    50 %

F.S. : 2000    Jc = 1

**FIG.12** BISMUTH BASED, REDUCTION RATIO : 0 % , $J_C$ = 110 A/cm²

PRIOR TO ROLLING

EP 0 357 779 A1

**FIG. 13** BISMUTH BASED, REDUCTION RATIO : 40 % Jc = 1.2 x 10$^4$ A/cm$^2$

AFTER ROLLING

EP 0 357 779 A1

# INTERNATIONAL SEARCH REPORT

International Application No PCT/JP88/01334

## I. CLASSIFICATION OF SUBJECT MATTER (if several classification symbols apply, indicate all) [6]

According to International Patent Classification (IPC) or to both National Classification and IPC

Int.Cl$^4$   H01B12/04, H01B13/00

## II. FIELDS SEARCHED

| Minimum Documentation Searched [7] | |
|---|---|
| Classification System | Classification Symbols |
| IPC | H01B12/00-13/00 |

| Documentation Searched other than Minimum Documentation to the Extent that such Documents are Included in the Fields Searched [8] | |
|---|---|
| Jitsuyo Shinan Koho | 1926 - 1989 |
| Kokai Jitsuyo Shinan Koho | 1971 - 1989 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| P | JP, A, 63-279512 (Toshiba Corp.) 16 November 1988 (16. 11. 88) (Family: none) | 1, 2, 4, 5 |
| P | JP, A, 63-282152 (Toshiba Corp.) 18 November 1988 (18. 11. 88) (Family: none) | 1, 2, 4, 5 |
| E | JP, A, 64-617 (Sumitomo Electric Industries, Ltd.) 5 January 1989 (05. 01. 89) (Family: none) | 1, 2, 4, 5 |
| A | Physical Review Letters, Vol.58, No.9, 2 March 1987 (02. 03. 87) M. K. Wu and eight others, "Superconductivity at 93K in a New Mixed-Phase Y-Ba-Cu-O Compound System at Ambient Pressure" P.908-P.910 | 1-6 |

* Special categories of cited documents: [10]

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

## IV. CERTIFICATION

| Date of the Actual Completion of the International Search | Date of Mailing of this International Search Report |
|---|---|
| March 15, 1989 (15. 03. 89) | April 3, 1989 (03. 04. 89) |
| International Searching Authority | Signature of Authorized Officer |
| Japanese Patent Office | |

Form PCT/ISA/210 (second sheet) (January 1985)